(19) Europäisches Patentamt
European Patent Office
Office européen des brevets

(11) **EP 0 901 225 B1**

(12) **EUROPÄISCHE PATENTSCHRIFT**

(45) Veröffentlichungstag und Bekanntmachung des Hinweises auf die Patenterteilung:
**04.07.2007 Patentblatt 2007/27**

(51) Int Cl.:
*H03H 17/02* *(2006.01)*    *H03H 17/04* *(2006.01)*

(21) Anmeldenummer: **98115485.9**

(22) Anmeldetag: **18.08.1998**

(54) **Digitale, durchstimmbare Filteranordnung**

Digital tunable filter device

Dispositif de filtrage numérique accordable

(84) Benannte Vertragsstaaten:
**DE ES FR GB IT SE**

(30) Priorität: **02.09.1997 DE 19738226**

(43) Veröffentlichungstag der Anmeldung:
**10.03.1999 Patentblatt 1999/10**

(73) Patentinhaber: **Conti Temic microelectronic GmbH**
**90411 Nürnberg (DE)**

(72) Erfinder:
• **Schulter, Wolfgang, Dr.**
  **88709 Meersburg (DE)**
• **Driendl, Dieter**
  **88693 Deggenhausertal (DE)**
• **Kessler, Erwin**
  **88348 Saulgau-Bolstern (DE)**
• **Kleiner, Kurt**
  **88605 Messkirch (DE)**

(56) Entgegenhaltungen:
**DE-A- 19 511 148**         **US-A- 5 282 023**

• **U. TIETZE-CH. SCHENK: "HALBLEITER-SCHALTUNGSTECHNIK" 1993 , SPRINGER VERLAG , BERLIN, DE XP002162551 * Absatz [24.6.2]; Abbildungen ***
• **LAAKSO T I ET AL: "IMPLEMENTATION OF A TIME-VARYING MIMO SYSTEM WITH ERROR FEEDBACK" SIGNAL PROCESSING. EUROPEAN JOURNAL DEVOTED TO THE METHODS AND APPLICATIONS OF SIGNAL PROCESSING, NL, ELSEVIER SCIENCE PUBLISHERS B.V. AMSTERDAM, Bd. 33, Nr. 1, 1. Juli 1993 (1993-07-01), Seiten 81-93, XP000417763 ISSN: 0165-1684**

EP 0 901 225 B1

**Beschreibung**

Die Erfindung betrifft eine digitale durchstimmbare Filteranordnung gemäß dem Oberbegriff des Patentanspruchs 1, wie sie aus dem Buch Tietze/Schenk: Halbleiter-Schaltungstechnik, 10. Aufl. Springer Verlag 1993, im Kapitel "Digitale Filter" ab S. 791 ff. beschrieben wird.

Die praktische Umsetzung digitaler Filteranordnungen wird eingehend von Lacroix, Arild in: Digitale Filter : eine Einführung in zeitdiskrete Signale und Systeme, 2. Aufl. 1985 beschrieben und kann darüber hinaus beispielsweise aus der WO 96/31001 entnommen werden.

Nachteil der bisher bekannten digitalen Filteranordnungen war, daß sie entweder nicht oder nur mittels mindestens zweier Parameter durchstimmbar waren, wobei die Parameter in einer Look-Up-Tabelle programmiert vorgegeben werden, da die numerischen Zusammenhänge zwischen den Parametern sehr komplex sind und eine Berechnung dieser zu aufwendig ist. Derartige zweiparametrig durchstimmbare Filter erfordern aber eine Look-Up-Tabelle und eine entsprechende Zugriffssteuerung.

Aufgabe der Erfindung ist es, eine digitale durchstimmbare Filteranordnung aufzuzeigen, die äußerst einfach zu realisieren ist.

Die Aufgabe wurde durch die kennzeichnenden Merkmale des Patentanspruchs 1 gelöst, indem die Filteranordnung mittels nur eines Parameters durchstimmbar ist und auf einfachen numerischen Schritten beruht, welche äußerst einfach hardwaremäßig realisiert werden können. So basiert die vorgegebene Differenzengleichung nur auf den bekanntermaßen einfach realisierbaren Operationen Addition, Zeitverzögerung um eine Zeiteinheit und Multiplikation mit dem Parameter. Um das Filter durchzustimmen, bedarf es einzig einer der gewünschten Frequenzänderung proportinalen Änderung des Parameters. Eine komplizierte mathematische Berechnung von Filterkonstanten entfällt. Der Durchstimmbereich einer derartigen Filteranordnung kann durch entsprechende Wahl der Abtastfrequenz und der Bit-Breite der Register und Multiplizierer entsprechend variiert und ausgedehnt werden. Insbesondere auch sehr niedrige, analog nicht realisierbare Grenzfrequenzen sind möglich.

Besonders vorteilhaft ist außerdem, daß der Nenner mit $(1-2\alpha)$ für alle $\alpha$, welche die Bedingung $0<\alpha<1$ erfüllen, reell ist und somit die Filteranordnung stabil bleibt und keine Schwingungserscheinungen zeigt.

Durch entsprechende Wahl des Operators wird die Filteranordnung eine Tief- oder Hochpaßcharakteristik aufweisen.

Durch eine Hintereinanderschaltung oder Kaskadierung dieser Filteranordnung können Filteranordnungen höherer Ordnung oder Bandpaßcharakteristiken erzielt werden.

Eine derartige durchstimmbare Filteranordnung läßt sich bevorzugt zur Tiefpaßfilterung eines abgetasteten, digitalisierten Motorstroms bei einem Verfahren zur lastabhängigen Steuerung eines Motors verwenden.

Um bspw. externe Störungen oder durch Doppelkommutierungen hervorgerufene Stromschwankungen unterscheiden zu können, ist es erforderlich, den Motorstrom entsprechend tiefpaßzufiltern. Da die Motordrehzahl aber sehr stark variieren kann, ist eine sehr breitbandig durchstimmbare Filteranordnung, wie die in der Erfindung gelehrte, erforderlich. Da die Drehzahl sich insbesondere auch im Bereich einiger weniger Hertz bewegen kann, wenn sich das Lastmoment am Motor stark erhöht, muß die durchstimmbare Filteranordnung auch in diesem niederstfrequenten Bereich durchstimmbar sein. Dies läßt sich mit herkömmlichen analogen Filtern nicht zuverlässig realisieren. Die erfindungsgemäße Filteranordnung kann auch die erforderlichen sehr tiefen Grenzfrequenzen erreichen. Da bei Motorsteuerungen außerdem meist eine direkte lineare Abhängigkeit zwischen Motordrehzahl und erforderlicher Grenzfrequenz besteht, erweist sich die Anwendung der erfindungsgemäßen, einparametrigen Filteranordnung als besonders vorteilhaft.

Die Erfindung wird nachfolgend anhand eines Ausführungsbeispiels und der Figuren erläutert. Kurze Beschreibung der Figuren:

Figur 1      Blockschema der Filteranordnung

Figur 2      Grenzfrequenz der Filteranordnung in Abhängigkeit vom Durchstimm - Parameter $\alpha$

Figur 3      Blockschaltbild einer Anordnung zur lastabhängigen Motorsteuerung, bei der die abgetasteten, digitalisierten Meßwerte des Motorstroms entsprechend mit der Filteranordnung gefiltert werden

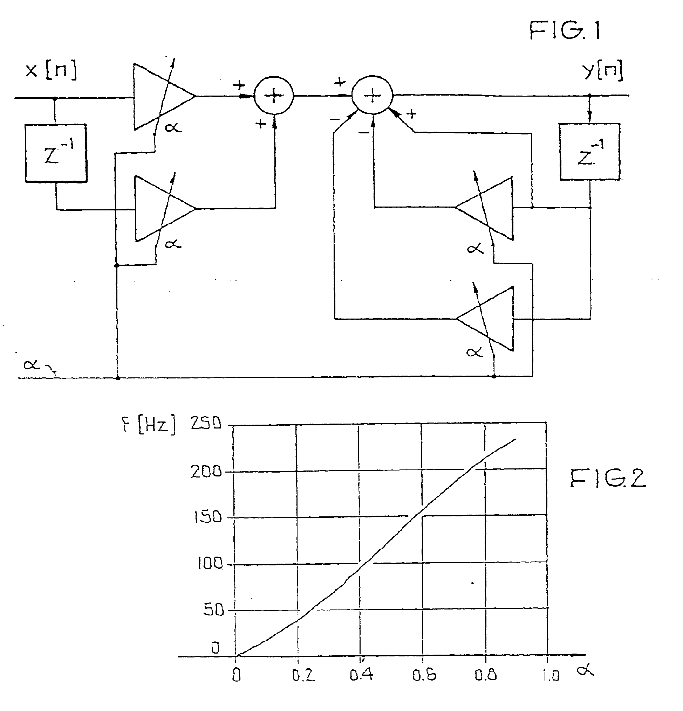

Das in Figur 1 dargestellte Blockschema der Filteranordnung zeigt als Ausführungsbeispiel einen Tiefpaßfilter 1. Ordnung. Durch Wahl des Operators "$\pm$"ein "-" anstelle des "+" würde ein Hochpaß und durch Kaskadierung mehrerer als Tief- und/oder Hochpässe ausgebildeter Filterelemente ein Bandpaßfilter oder ein Filter höherer Ordnung gebildet.

Am Eingang der Filteranordnung liegen die abgetasteten, digitalisierten Meßwerte des Motorstroms an, wobei x[n] für den n-ten Eingangswert steht. Am Ausgang wird jeweils entsprechend der n-te Ausgangswert y[n] bereitgestellt. Dieser ergibt sich gemäß der Differenzengleichung

$y[n] = \alpha \cdot (x[n] \pm x[n-1]) + (1 - 2\alpha) \cdot y[n-1]$. Dafür sind der Eingang einerseits mit einem ersten Verstärker C1 und andererseits mit einem ersten Verzögerungsglied T1 verbunden. Das von C1 um den Faktor $\alpha$ verstärkte (bzw. gedämpfte, da $0< \alpha <1$) Eingangssignal x[n] wird in einem ersten Summerierer S1 zu dem in einem zweiten Verstärker C2 um α verstärkte und in T1 für einen zeittakt gespeicherte Eingangssignal x[n-1] addiert.

Das Ergebnis von S1 wird einem zweiten Summierer S2 zugeführt und dort mit

- dem in einem Verzögerungsglied T2 für einen Zeittakt gespeicherten Ausgangssignal y[n-1] addiert sowie
- das um α in den Verstärkern C3 und C4 verstärkte in T2 verzögerte Ausgangssignal y[n-1] zweifach subtrahiert.

Am Ausgang von S2 liegt dann das Ausgangssignal y[n] an, welches außerdem vom Verzögerungsglied T2 für einen Zeittakt und damit den nächsten Abtastwert gespeichert wird. Alle Verstärker C1 bis C4 weisen die gleiche Verstärkung α (bzw. Dämpfung, da 0< α <1) auf. Die Verstärker C1 bis C4 können dabei sowohl Analogverstärker als auch digitale Multiplizierer sein. Die Bitbreite der Verzögerungsglieder T1 und T2, der Summierer S1 und S2 sowie ggfs. der als digitale Multiplizierer ausgeführten Verstärker C1 bis C4 ergibt sich dabei in bekannter weise aus der Bitbreite des abgetasteten, digitalisierten Eingangssignals. Die Abtastfrequenz ist dabei gemäß dem Abtasttheorem mindestens doppelt so groß wie die größte noch zulässige Drehzahl zu wählen. Die Bitbreite ist dem gegenüber so zu wählen, daß bei der kleinsten noch zulässigen Drehzahl zumindest noch das niederstsignifikante Bit erreicht wird.

Figur 2 zeigt den skizzierten Verlauf der Grenzfrequenz der Filteranordnung in Abhängigkeit vom Durchstimm - Parameter α für einen Tiefpaßfilter bei einer Abtastfrequenz von 500 Hz. Für 8 - Bit breite Signale ergibt sich eine praktische untere Grenze des Durchstimmbereichs zu $500\,Hz/2^8 \approx 2\,Hz$. Der skizzierte lineare Verlauf in Figur 2 ist jedoch durch die Digitalisierung von α bei als digitale Multiplizierer ausgeführten Verstärker C1 bis C4 natürlich nicht kontinuierlich sondern nur in $1/2^8$ - Schritten. Generell macht jedoch die Figur 2 noch einmal deutlich, daß mittels des Durchstimm - Parameters α ein sehr großer Durchstimmbereich und insbesondere auch sehr niedrige Grenzfrequenzen eingestellt werden können.

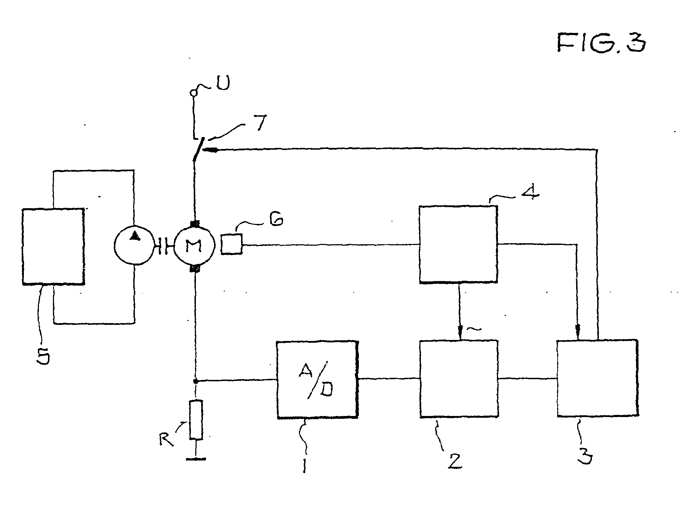

Figur 3 zeigt im Blockschaltbild den über dem Shuntwiderstand R erfaßten Motorstrom $I_M$ aus dem Motor M, welcher in einer A/D - Wandler 1 zunächst abgetastet und digitalisiert wird. Der digitalisierte Motorstromwert wird vom Ausgang des A/D-Wandlers 1 zunächst zur erfindungsgemäßen Filteranordnung, hier als Block 2 dargestellt, geführt und dort tiefpaßgefiltert. Der so von Störungen bereinigte Motorstromwert wird dann der nachgeordneten Auswerteeinheit 3 zugeführt und der Motor M über die Steuermittel 7, hier im einfachsten Fall als Schalter dargestellt, angesteuert. Eine Drehzahlerfassungsschaltung 4 ermittelt bspw. mittels eines Hallsensors 6 die aktuelle Drehzahl. Die Drehzahlerfassungsschaltung 4 weist eine Kopplung zur Filteranordnung 2 auf, mit der die Drehzahlerfassungsschaltung 4 den Durch-stimm - Parameter α für die Verstärker entsprechend der ermittelten aktuellen Drehzahl nachführt und so drehzahlabhängige Störungen herausgefiltert werden. Die Auswerteeinheit 3 ermittelt aus dem Wert des Motorstroms und aus der Drehzahl eine lastabhängige Größe und steuert entsprechend den Motor M über Steuermittel 7. Im gezeigten Ausführungsbeispiel wird vom Motor M eine Pumpe P für eine hydraulische Lenkhilfe 5 angetrieben. Im Ruhezustand (keine Lenkbewegung) wird zur Energieeinsparung die Pumpe P typischerweise bei einer niedrigen Drehzahl betrieben. Bei Lenkbewegungen soll jedoch möglichst schnell (ca 30-50 ms) die Pumpe auf eine höhere Drehzahl/Förderung gesteuert werden. Bei einer Lenkbewegung wird ein Torsionsventil eine hydraulische Verbindung zu einem Lenkhilfszylinder herstellen und der Motorstrom $I_M$ wird aufgrund des Druckanstiegs um einen gewissen Betrag ansteigen. Durch Detektion über den Motorstrom $I_M$ kann eine Lastzunahme der Pumpe P bei Lenkbetätigung ohne einen Drucksensor detektiert werden.

## Patentansprüche

1. Digitale durchstimmbare Filteranordnung, die wenigstens ein Filterelement aufweist, das mittels genau eines Durchstimm - Parameters α durchgestimmt wird **dadurch gekennzeichnet, daß** $0<\alpha<1$ ist und daß den Filterelement die Übertragungsfunktion

$$H(z) = \alpha \cdot \frac{1 \pm z^{-1}}{1 + (2\alpha - 1) \cdot z^{-1}}$$

beziehungsweise die zugehörige Differenzengleichung $y[n]=\alpha\cdot(x[n]\pm x[n-1])+(1-2\alpha)\cdot y[n-1]$ realisiert, wobei x[n] der n-te Eingangswert, y[n] der n-te Ausgangswert ist und n die Abtastschrittfolge des digitalen Filterelements ist.

2. Digitale durchstimmbare Filteranordnung gemäß Anspruch 1, **dadurch gekennzeichnet, daß** ein Filterelement durch Ersetzen des Operators "$\pm$" durch ein "+" ein Tiefpaß, durch Ersetzen des Operators durch ein "-" ein Hochpaß gebildet wird.

3. Digitale durchstimmbare Filteranordnung, **dadurch gekennzeichnet, daß** durch Kaskadierung wenigstens eines ersten, als Hochpaß gemäß Anspruch 2 ausgebildeten Filterelementes und eines wenigstens eines zweiten, als Tiefpaß gemäß Anspruch 2 ausgebildeten Filterelementes ein durchstimmbarer Bandpaß oder eine durchstimmbare Bandsperre gebildet wird.

4. Verwendung der durchstimmbaren Filteranordnung gemäß Anspruch 2 zur Tiefpaßfilterung abgetasteter, digitalisierter Meßwerte des Motorstroms bei einem Verfahren zur lastabhängigen Motorsteuerung , wobei der Durchstimm - Parameter ($\alpha$) in Abhängigkeit von der bisher ermittelten Motordrehzahl gesteuert wird.

**5.** Verwendung der durchstimmbaren Filteranordnung gemäß Anspruch 2 zur Tiefpaßfilterung abgetasteter, digitalisierter Meßwerte des Motorstroms bei einem Verfahren zur lastabhängigen Motorsteuerung , wobei der Durchstimm - Parameter ($\alpha$) in Abhängigkeit von der bisher ermittelten Motorstrom und Motorspannung gesteuert wird.

**Claims**

**1.** A digitally variable filter arrangement which comprises at least one filter element, which is varied using precisely one variability parameter, **characterized in that** $0<\alpha<1$, and that the filter element realises the transfer function

$$H(z) = \alpha \cdot \frac{1 \pm z^{-1}}{1 + (2\alpha - 1) \cdot z^{-1}}$$

or the related differential equation $Y[n] = \alpha \cdot (x[n] \pm x[n-1]) + (1-2\alpha) \cdot y[n-1]$, whereby $x[n]$ is the nth input value, $y[n]$ is the nth output value and n is the scanning sequence of the digital filter element.

**2.** A digitally variable filter arrangement according to claim 1, **characterized in that** a low-pass filter element is formed by replacing the operator "$\pm$" with a "+" and a high-pass filter element is formed by replacing the operator with a "-".

**3.** A digitally variable filter arrangement, **characterized in that** by cascading at least one first filter element which is formed as a high-pass in accordance with claim 2 and at least one filter element which is formed as a low-pass in accordance with claim 2, a variable band pass or a variable band block is formed.

**4.** The use of the variable filter arrangement according to claim 1 for the low-pass filtration of scanned, digitalised measurement values of the motor current with a method for load-dependent motor control, whereby the variability parameter ($\alpha$) is controlled depending on the previously determined motor torque.

**5.** The use of the variable filter arrangement according to claim 2 for the low-pass filtration of scanned, digitalised measurement values of the motor current with a method for load-dependent motor control, whereby the variability parameter ($\alpha$) is controlled depending on the previously determined motor current and motor voltage.

**Revendications**

**1.** Assemblage de filtres numérique accordable, lequel présente au moins un élément de filtre, lequel est accordé au moyen d'exactement un paramètre d'accord $\alpha$, **caractérisé en ce que** $0 < \alpha < 1$ et **en ce que** l'élément de filtre réalise la fonction de transfert

$$H(z) = \alpha \cdot \frac{1 \pm z^{-1}}{1 + (2\alpha - 1) \cdot z^{-1}}$$

ou encore l'équation aux différences correspondante $y[n]=\alpha.(x[n] \pm x[n-1])+(1-2\alpha).y[n-1]$, $x[n]$ étant la n-ième valeur d'entrée, $y[n]$ la n-ième valeur de sortie et n la suite des pas d'échantillonnage de l'élément de filtre numérique.

**2.** Assemblage de filtres numérique accordable selon la revendication 1, **caractérisé en ce qu'**un élément de filtre passe-haut est formé par le remplacement de l'opérateur « $\pm$ » par un « + », et qu'un élément de filtre passe-bas est formé par le remplacement de l'opérateur par un « - ».

**3.** Assemblage de filtres numérique accordable, **caractérisé en ce que**, par le cascadage d'au moins un premier élément de filtre formé comme passe-haut conformément à la revendication 2 et d'au moins un deuxième élément de filtre formé comme passe-bas conformément à la revendication 2, un passe-bande accordable ou un coupe-bande accordable est formé.

**4.** Utilisation de l'assemblage de filtres selon la revendication 2 pour le filtrage passe-bas de valeurs de mesure du courant de moteur échantillonnées numérisées sur un procédé pour la commande de moteur en fonction de la charge, le paramètre d'accord ($\alpha$) étant commandé en fonction du régime du moteur déterminé jusqu'alors.

**5.** Utilisation de l'assemblage de filtres selon la revendication 2 pour le filtrage passe-bas de valeurs de mesure du courant de moteur échantillonnées numérisées sur un procédé pour la commande de moteur en fonction de la charge, le paramètre d'accord ($\alpha$) étant commandé en fonction du régime du moteur et de la tension de moteur déterminés jusqu'alors.

FIG. 1

FIG. 2

FIG.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

* WO 9631001 A

**In der Beschreibung aufgeführte Nicht-Patentliteratur**

* Halbleiter-Schaltungstechnik. **BUCH TI-ETZE/SCHENK.** Digitale Filter. Springer Verlag, 1993, vol. 10, 791 ff